# EUROPÄISCHE PATENTANMELDUNG

(11) **EP 4 311 624 A1**
(43) Veröffentlichungstag der Anmeldung: **31.01.2024**
(21) Anmeldenummer: 22186969.6
(22) Anmeldetag: 26.07.2022
(51) Int. Cl.: B23K 35/02, B23K 1/00, H01L 23/00

(54) **VERFAHREN ZUM AUFSCHMELZEN EINES LOTMATERIALS IN MAGNETISCHEN WECHSELFELDERN**

(71) Anmelder: Siemens Aktiengesellschaft, 80333 München (DE)
(72) Erfinder: Schwarz, Markus, 80798 München (DE); Stegmeier, Stefan, 81825 München (DE); Walbrecker-Baar, Christian, 85757 Karlsfeld (DE)
(74) Vertreter: Siemens Patent Attorneys

(57) **Zusammenfassung**

Die Erfindung betrifft ein Verfahren zum Aufschmelzen eines Lotmaterials zum Fügen und/oder Lösen einer Lötverbindung, wobei im Lotmaterial eingebrachte Nanopartikel magnetische Energie aus einem magnetischen Wechselfeld dissipieren, im Wesentlichen durch Relaxationsprozesse nach Brown und Neel, was zur Erwärmung und schließlich zum Aufschmelzen des Lotmaterials führt. Des Weiteren betrifft die Erfindung eine Baugruppe, welche wenigstens eine Lötverbindung aufweist, die durch das erfindungsgemäße Verfahren gebildet oder gelöst wird.

## Beschreibung

Die Erfindung betrifft ein Verfahren zum Aufschmelzen eines Lotmaterials zum Fügen und/oder Lösen einer Lötverbindung. Des Weiteren betrifft die Erfindung eine Baugruppe, welche wenigstens eine Lötverbindung aufweist, die durch das erfindungsgemäße Verfahren gebildet oder gelöst wird.

### Stand der Technik

Bisherige Anforderungen an elektronische Baugruppen waren auf verringertes Gewicht oder verringertes Volumen gerichtet, eine höhere Systemleistung bei kürzerer Signallaufzeit oder eine erhöhte Zuverlässigkeit bei gleichzeitig minimalen Kosten. Auch thermische, mechanische oder elektromagnetische Anforderungen wurden vom Markt an elektronische Baugruppen gestellt. Elektronische Baugruppen umfassen üblicherweise integrierte sowie diskrete Bauelemente. Die Bauelemente sind dabei insbesondere untereinander aber auch mittels eines Verdrahtungsträgers elektrisch und mechanisch verbunden.

Aktuelle und zukünftige Anforderungen werden vermehrt auch auf Umweltgerechtheit gerichtet. Bei elektrischen Baugruppen werden herkömmlich die Komponenten nicht einzeln recycelt. Bisher kommen mechanische Verfahren wie beispielsweise Schreddern zum Einsatz, um die Baugruppen nach ihrer Lebensdauer zu zerkleinern, und anschließend in Folgeprozessen wie beispielsweise magnetischem Abscheiden, Zentrifugieren etc. grob die Materialien zu trennen bzw. zurückzugewinnen. Bisher erfolgt kein gezieltes Recycling einzelner Komponenten oder einzelner Bauelemente.

Zwar ist es technisch möglich, ein Lösen aller Bauteile zu ermöglichen, sei es eine mechanische, eine elektrische oder elektronische Baugruppe. Durch globales Erwärmen einer gesamten Gruppe, ist dies jedoch auf der einen Seite sehr energieintensiv, auf der anderen Seite können zahlreiche Komponenten durch ungeregelten Wärmeeintrag geschädigt werden. Die Einbringung der notwendigen Wärme beim Entlöten erfolgt in der Regel durch Öfen, Heizplatten, Lötkolben, Induktion oder offene Flammen. Bei jedem der Verfahren wird nicht nur das Lot erwärmt, sondern auch die umgebenden Materialien. Je nach Prinzip, lokal unterschiedlich: Bei Erhitzung im Ofen wird alles übermäßig erhitzt, beim Lötkolben zwar nur partiell, jedoch würden auch hier benachbarte Baugruppen in Mitleidenschaft gezogen. Auch beim Induktionslöten wird die erforderliche Hitze maßgeblich durch die induzierten Wirbelströme der Fügepartner erzeugt. Auch müssen diese stets elektrisch leitfähig sein. Durch die indirekte Erwärmung ist die eingebrachte Energie beim Entlötprozess viel größer als die tatsächlich zum Aufschmelzen des Lotes benötigte Energie. Beim Entlöten mit dem Lötkolben etwa, werden bei bestimmten Lötaufgaben die umliegenden Partner nur minimal erwärmt, z. B. beim Löten einer Litze an einen Pin. Jedoch muss auch hier auf die richtige maximale Temperatur geachtet werden, da es sonst zu einer Überhitzung an der Lötstelle und der umgebenden Materialien kommt. Weiterhin lassen sich die meisten Lötprozesse aus technischer und wirtschaftlicher Sicht gar nicht mit Lötkolben realisieren. Zum einen werden Entlötprozesse mit Lötkolben nur für nicht automatisierte Spezialfälle bei der Produktion verwendet, da die Kosten für nicht automatisierte maschinelle Prozesse viel zu hoch wären. Technisch gesehen sind die wenigsten Lötstellen direkt kontaktierbar. Beispielsweise lassen sich Halbleiterchips wie IGBTs nicht mit Lötkolben entlöten, da die Erwärmung unterhalb der nicht zugänglichen Chipfläche erfolgen müsste. In solchen Fällen ist bisher nur eine Entlötung in Öfen möglich.

Auch bei Reparaturen von Bauteilen und Baugruppen treten ähnliche Probleme auf. Muss beispielsweise eine defekte Lötstelle nachgelötet werden, die wie bei einem BGA nicht zugänglich ist, wird das gesamte Bauteil und die umliegende PCB miterwärmt, was negative Effekte auf die Qualität der Komponenten hat.

Die Unwirtschaftlichkeit derartiger Verfahren wird noch größer, wenn bei einer kompletten Baugruppe eine Durchwärmung erfolgen muss, um lediglich an bestimmte einzelne Bauelemente zu gelangen. Befindet sich ein Bauteil beispielsweise auf einem Kühler ist ein enorm hoher Energiebedarf notwendig, um den Kühler zu erwärmen.

Ausgehend vom zuvor beschriebenen Stand der Technik liegt der Erfindung die Aufgabe zugrunde, ein effizientes und selektives Entlöten von Teilen oder Komponenten einer Baugruppe zu ermöglichen.

Diese Aufgabe wird durch die Merkmale des unabhängigen Patentanspruchs 1 gelöst. Vorteilhafte Ausgestaltungen der Erfindung sind Gegenstand der Unteransprüche. Insbesondere soll die vorzuschlagende Lösung eine Baugruppe mit selektiv entlötbaren Baugruppen oder Bauelementen ermöglichen, wie in Patentanspruch 12.

Das erfindungsgemäße Verfahren zum Aufschmelzen eines Lotmaterials zum Fügen und/oder Lösen wenigstens einer ersten und wenigstens einer zweiten Lötverbindung, wobei ein Lotmittel das Lotmaterial und magnetische Nanopartikel umfasst, welche ein ferromagnetisches oder ferrimagnetisches Material aufweisen und einen Gewichtsanteil am gesamten Lotmittel zwischen 1 % und 30 % ausmachen, werden zumindest die folgenden Schritte vorgenommen: Einbringen einer ersten Leistung in ein erstes Lotmittel mittels eines ersten magnetischen Wechselfeldes, sodass das erste Lotmittel aufschmilzt, und Einbringen einer zweiten Leistung in ein zweites Lotmittel mittels eines zweiten magnetischen Wechselfeldes, sodass das zweite Lotmittel aufschmilzt, wobei sich das erste und das zweite magnetische Wechselfeld in zumindest einem Parameter unterscheiden.

Zweckdienlicherweise sind die zu unterscheidenden Lotmittel so gewählt, dass das erste magnetische Wechselfeld nicht geeignet ist, das zweite Lotmittel aufzuschmelzen sowie das zweite magnetische Wechselfeld nicht geeignet ist, das erste Lotmittel aufzuschmelzen. Bevorzugt unterscheiden sich die magnetischen Wechselfelder in zumindest einem Parameter. Die Parameter des magnetischen Wechselfeldes können insbesondere Frequenz und/oder Magnetfeldstärke sein. Die zwei verschiedenen Lotmittel sind beispielsweise über die Wahl des ferrimagnetischen oder ferromagnetischen Nanopartikelmaterials einstellbar, über den Gewichtsanteil der Nanopartikel oder über die Schmelztemperatur des Lotmaterials.

Dieses Verfahren hat den Vorteil nicht nur ein selektives, sondern auch ein sehr effizientes Entlöten von Einzelbauteilen oder Komponenten einer Baugruppe zu ermöglichen.

In einer vorteilhaften Ausführungsform der Erfindung wird bei dem Verfahren die Wechselfrequenz des ersten magnetischen Wechselfeldes auf die Größe der magnetischen Nanopartikel der ersten Lötverbindung eingestellt und die Wechselfrequenz des zweiten magnetischen Wechselfeldes auf die Größe der magnetischen Nanopartikel der zweiten Lötverbindung eingestellt. Unter Größe ist insbesondere der Durchmesser der Nanopartikel bei annähernd kugelförmigen Partikeln zu verstehen. Alternativ ist die maximale Ausdehnung eines Partikels zu verstehen. Insbesondere erfolgt eine Anpassung des magnetischen Wechselfeldes, insbesondere dessen Wechselfrequenz, gegebenenfalls auch dessen Magnetfeldstärke, auch auf folgende Faktoren: Neel-Relaxationszeit, Neel-Spin-Relaxation und/oder Blocking-Temperatur.

In einer weiteren vorteilhaften Ausführungsform der Erfindung wird bei dem Verfahren die Wechselfrequenz des ersten magnetischen Wechselfeldes auf den Volumenanteil der magnetischen Nanopartikel an der Lotmittelzusammensetzung des ersten Lotmittels eingestellt und die Wechselfrequenz des zweiten magnetischen Wechselfeldes auf den Volumenanteil der magnetischen Nanopartikel an der Lotmittelzusammensetzung des zweiten Lotmittels eingestellt. In einer weiteren vorteilhaften Ausführungsform der Erfindung wird bei dem Verfahren die Magnetfeldstärke des ersten magnetischen Wechselfeldes auf die Größe der magnetischen Nanopartikel des ersten Lotmittels eingestellt und die Magnetfeldstärke des zweiten magnetischen Wechselfeldes auf die Größe der magnetischen Nanopartikel des zweiten Lotmittels eingestellt. Auch eine Kombination der beiden Lotmitteleinstellungen durch Nanopartikelgröße und Nanopartikelanteil ist möglich. Dies erhöht die Möglichkeit der selektiven Entlötung jedes einzelnen Bauteils der Baugruppe.

Auch eine Anpassung oder Veränderung des Lotmaterials, z. B. in Bezug auf die Schmelztemperatur des Lotmaterials ist für eine weitere Erhöhung der Selektivität des Verfahrens möglich. Bevorzugt aber werden die Nanopartikel variiert. Diese können in ihrer Materialzusammensetzung variiert werden, in ihrem Massenanteil am Lotmittel sowie in ihrer Größe.

In einer sehr zweckdienlichen Ausführungsvariante der Erfindung wird bei dem Verfahren wenigstens ein magnetisches Wechselfeld als fokussiertes magnetisches Wechselfeld erzeugt und das Lotmittel in den Fokusbereich des fokussierten magnetischen Wechselfeldes eingebracht. Ein fokussiertes Wechselfeld kann die Selektivität des Gesamtverfahrens noch erhöhen. Insbesondere können dadurch bei eher entfernt positionierten Bauelementen gleiche Lotmittel verwendet werden, die benachbarten Baugruppen können mit unterschiedlichen Lotmitteln versehen sein.

In einer Weiterführung der Ausführungsvariante mit dem magnetischen fokussierten Wechselfeld wird bei dem Verfahren das Einbringen des Lotmittels in den Fokusbereich durch Verschieben des Fokusbereichs über die Baugruppe und/oder durch Verschieben der Baugruppe in oder durch den Fokusbereich erwirkt. Es gibt also unterschiedliche Verfahr- beziehungsweise Rastermöglichkeiten, um die verschiedenen Bauelemente auf einer Baugruppe in den Fokusbereich des magnetischen Wechselfeldes zu positionieren.

In einer weiteren vorteilhaften Ausführung der vorbeschriebenen Variante mit dem fokussierten elektromagnetischen Wechselfeld wird die Erzeugung des fokussierten magnetischen Wechselfeldes mittels wenigstens zwei Magnetspulen unterschiedlicher Orientierung der magnetischen Pole vorgenommen. Bei dieser Ausführungsvariante werden somit zwei sich überlagernde magnetische Wechselfelder erzeugt, wobei vorteilhaft die Bereiche hoher magnetischer Flussdichte in einem Fokusbereich überlagert sind. Bei dieser Variante wird somit eine noch stärkere Fokussierung der lokalen Erwärmung auf einen eng eingegrenzten Bereich bewirkt als dies mit nur einer Magnetspule bzw. mit nur einer magnetischen Vorrichtung möglich wäre. Die Größe des Fokusbereichs kann dabei je nach Anwendung unterschiedlich sein. Für Lötungen von Surface-Mount-Devices oder Ball-Grid-Arrays die Fokusgröße im Submillimeterbereich liegen für großflächige Lötbereiche, wie beispielsweise im Bahntechnikbereich oder zum Löten von Rohren kann die Fokusgröße aber auch wesentlich größer sein und sogar im Meterbereich liegen.

Alternativ zu der Erzeugung eines engen Fokusbereichs mit zwei überlappenden Magnetfeldern kann eine Fokussierung des Magnetfeldes auch durch eine oder mehrere flussführende Elemente erreicht werden. So können z. B. zwei konisch aufeinander zulaufende Eisenkerne zu beiden Seiten der Lötstelle angeordnet werden, um das Magnetfeld auf einen Fokusbereich in geeigneter Größe zu bündeln.

Allgemein und unabhängig von der Anzahl und räumlichen Anordnung der verwendeten Magnetspulen kann die Frequenz des magnetischen Wechselfeldes im Bereich einiger 100 kHz, insbesondere zwischen 100 kHz und 1000 kHz und beispielsweise im Bereich um etwa 400 kHz liegen. Bei einer Frequenz in einem solchen Bereich kann durch die entsprechenden Relaxationsprozesse in den magnetischen Nanopartikeln ein effizienter Wärmeeintrag in das Lotmittel erreicht werden.

In einer weiteren vorteilhaften Ausführungsform der Erfindung werden bei dem Verfahren zum Aufschmelzen eines Lotmaterials superparamagnetische Nanopartikel verwendet. Vorteilhaft ist die Größenskala der magnetischen Nanopartikel im Bereich von 100 nm oder darunter. Diese Nanopartikel enthalten ferromagnetische oder ferrimagnetische Materialkomponenten. Aufgrund ihrer geringen Partikelgröße sind die Nanopartikel insgesamt superparamagnetisch. Diese Eigenschaft ermöglicht eine starke lokale Erwärmung der magnetischen Nanopartikel im magnetischen Wechselfeld und somit den für das Aufschmelzen benötigten Energieeintrag in das Lotmittel.

Beispielsweise weisen die magnetischen Nanopartikel eine Curie-Temperatur auf, welche in einem Bereich zwischen 100°C und 1200°C, insbesondere zwischen 150°C und 400°C liegt. In einer besonders vorteilhaften Ausführungsform der Erfindung weist die Verteilung der Curie-Temperaturen der einzelnen magnetischen Nanopartikel eine Halbwertsbreite von höchstens 50°C, insbesondere von höchstens 30°C auf.

Wichtig für die vorliegende Erfindung ist also, dass das Lotmittel sowohl die beschriebenen magnetischen Nanopartikel als auch das metallische Lotmaterial enthält. Durch das Aufschmelzen des metallischen Lotmaterials wird die eigentliche Lötverbindung ausgebildet, ähnlich wie bei einer herkömmlichen Lötpaste. Die endgültige, mechanisch dauerhafte Lötverbindung wird dabei in dem Moment gebildet, in dem der Wärmeeintrag unterbunden bzw. begrenzt wird und das Lotmaterial wieder zu einem Festkörper erstarrt. Entsprechend wird die elektrische Leitfähigkeit der gebildeten Lötverbindung im Wesentlichen durch das erstarrte metallische Lotmaterial vermittelt.

In einer weiteren vorteilhaften Ausführungsform der Erfindung werden in dem Verfahren zum Aufschmelzen eines Lotmaterials ferromagnetische oder ferrimagnetische Materialien verwendet, welche eine metallische Legierung oder ein Metalloxid umfassen, wobei Legierung oder Metalloxid zumindest eine der Elemente Eisen, Cobalt oder Nickel aufweisen.

Das zuvor beschriebene erfindungsgemäße Verfahren oder eine seiner Ausführungsformen kann dazu hergenommen werden, eine Baugruppe zu bilden, welche wenigstens zwei Lötverbindungen aufweist, welche durch ein Verfahren gemäß der Erfindung gefügt oder gelöst werden, wobei eine Lötverbindung einen ersten Lötpartner und einen zweiten Lötpartner umfasst, welche Lötpartner durch ein Lotmittel verbindbar oder verbunden sind, welches Lotmittel ein metallisches Lotmaterial und eine Vielzahl von darin einbetteten magnetischen Nanopartikeln umfasst, wobei sich die Lotmittelzusammensetzung der zweiten Lötverbindung von der Lotmittelzusammensetzung der ersten Lötverbindung unterscheidet.

Eine derartige Baugruppe hat den Vorteil selektiv recycelbar zu sein und auch bereits in ihrer Herstellung eine sehr gute Energiebilanz aufzuweisen, da durch das direkte intrinsische Erhitzen des Lots der Lötprozess mit geringem Energieaufwand erfolgt. Darüber hinaus weist eine derartige Baugruppe eine hohe Zuverlässigkeit auf, da keine unnötige Erwärmung und damit auch keine unnötige thermische Belastung der anderen Materialien und Komponenten erfolgt. Die Wärmeerzeugung durch Magnetfelder erfolgt derart schnell, dass die Prozesszeiten herabgesetzt werden können. Überhitzung wird vermieden. Schon allein durch die eingestellte Curie-Temperatur, ab der eine Wärmeerzeugung unterbrochen wird.

In einer vorteilhaften Ausgestaltung der Erfindung ist der erste Lötpartner der Baugruppe ein elektrischer Schaltungsträger und die zweiten Lötpartner jeweils elektrische oder elektronische Bauelemente. Eine derartig hergestellte Baugruppe kann auch im Feldeinsatz repariert werden, selbst mit eingebauter Platine. Auch Szenarien wie Löten oder Reparieren von Sensoren, die an Anlagen angebracht sind, sind denkbar. Selbst Lötungen von Rohren können damit im Feldeinsatz erfolgen.

Das beschriebene erfindungsgemäße Verfahren und seine Ausgestaltungen sowie die angegebene Baugruppe ermöglichen u. a. Multitemperaturentlötungen innerhalb einer Baugruppe. Durch Verwendung von CMPs mit unterschiedlichen Schmelzpunkten ist es möglich, Bauteile nach Wertigkeit, Art, Kosten oder anderen Kriterien zu clustern. Durch Erhöhen globaler Entlöttemperatur durch die magnetischen Felder können so gezielt nacheinander Gruppen aus einem Cluster entlötet werden. Beispielsweise erst die MOSFETs bei 220°C, gefolgt von Dioden bei 235°C. Auch eine automatisiert angeschlossene Sortierung kann mit dem Verfahren kombiniert werden. Die beschriebene Baugruppe und das Verfahren liefern einen wichtigen Ansatz für eine wirtschaftliche Umsetzung von Second-Life-Ansätzen im Bereich von elektronischen und elektrischen Komponenten, welcher vor allem aus ökologischer Sicht für CO₂-Einsparung sowie Ressourceneinsparung immer mehr an Bedeutung gewinnt.

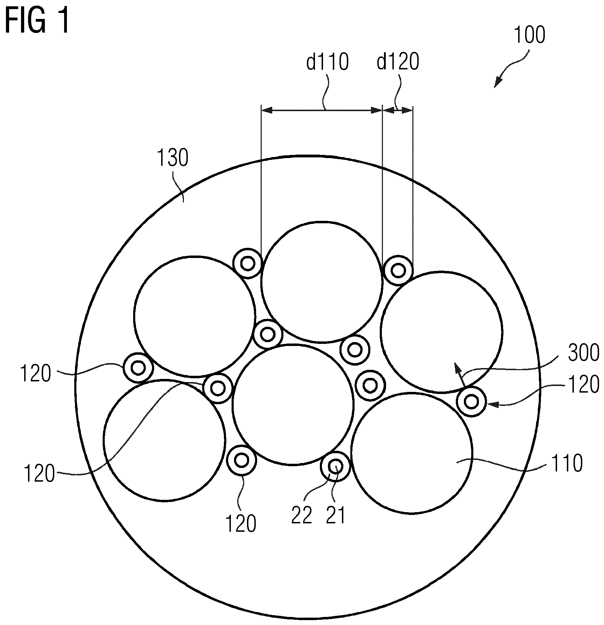

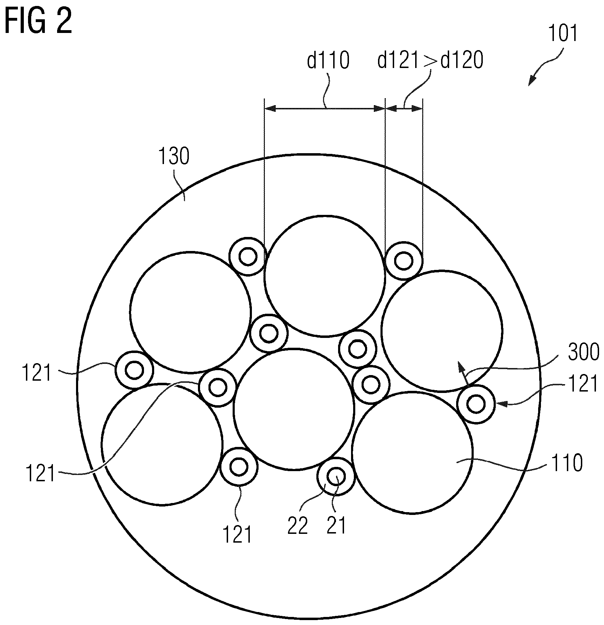

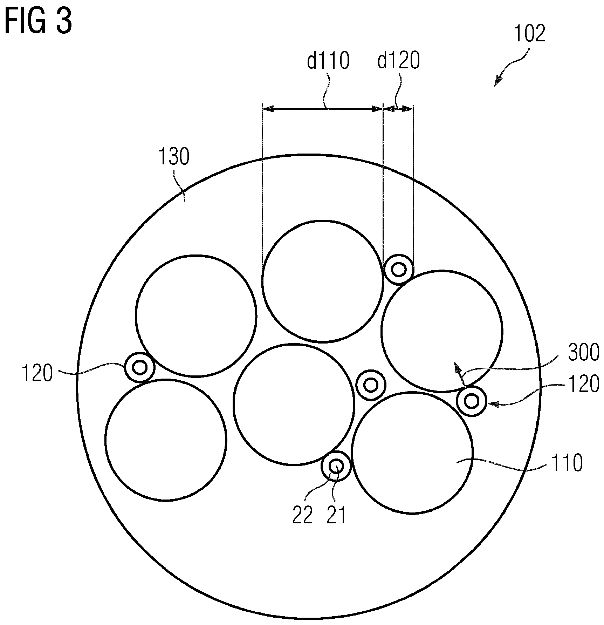

Im Folgenden wird die Erfindung anhand der in den Figuren 1 bis 7 dargestellten Ausführungsbeispielen näher beschrieben und erläutert. Weitere Merkmale, Eigenschaften und Vorteile der vorliegenden Erfindung ergeben sich aus der nachfolgenden Beschreibung unter Bezugnahme auf die beiliegenden Figuren. In den Ausführungsbeispielen und Figuren können gleiche oder gleich wirkende Elemente jeweils mit den gleichen Bezugszeichen versehen sein. Die dargestellten Elemente und deren Größenverhältnisse sind grundsätzlich nicht als maßstabsgerecht anzusehen, vielmehr können einzelne Elemente zur besseren Darstellbarkeit und/oder zum besseren Verständnis im Verhältnis größer dimensioniert dargestellt sein.

Auch wenn die Erfindung im Detail durch Ausführungsbeispiele näher illustriert und beschrieben wird, ist die Erfindung nicht durch die offenbarten Beispiele eingeschränkt.
Figur 1 zeigt die Zusammensetzung des Lotmittels 100 aus metallischem Lotmaterial 110 und magnetischen Nanopartikeln 120.
Figur 2 zeigt die Zusammensetzung eines zweiten Lotmittels 101 aus metallischem Lotmaterial 110 und magnetischen Nanopartikeln 121.
Figur 3 zeigt die Zusammensetzung eines dritten Lotmittels 102 aus metallischem Lotmaterial 110 und magnetischen Nanopartikeln 120.
Figur 4 und Figur 5 zeigen jeweils zwei Lötpartner 10, 20 in einem magnetischen Wechselfeld 200, 201.
Figur 6 zeigt Lötpartner 10, 20 in einem fokussierten magnetischen Wechselfeld.
Figur 7 zeigt eine Baugruppe und eine verschiebbare Vorrichtung zur Erzeugung eines magnetischen Wechselfeldes.

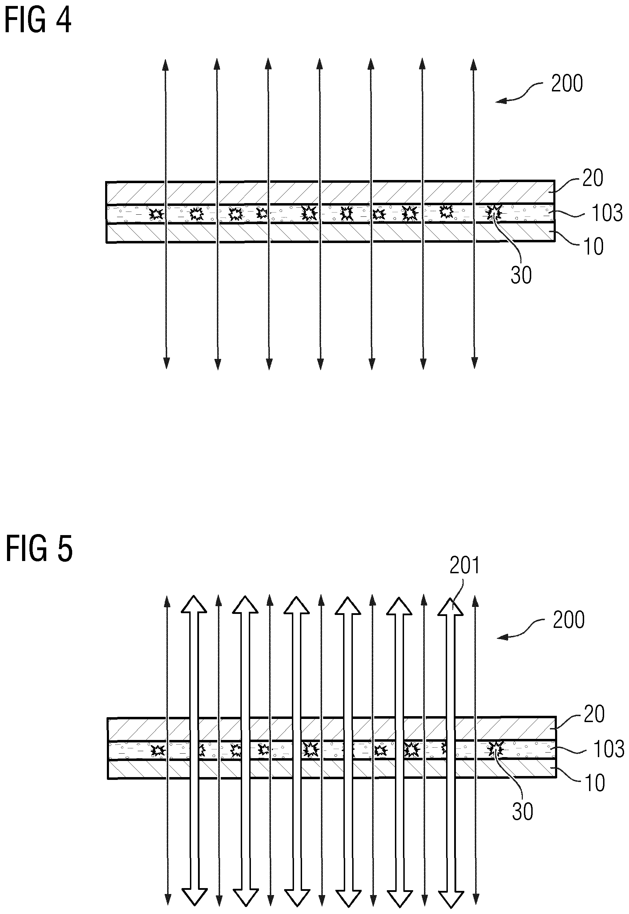

Die Figuren 1 bis 3 zeigen schematisch die Lotmittel 100, Zusammensetzung aus Lotmaterial 110 und Nanopartikeln 120, 121 in unterschiedlichen Größen und Zusammensetzungen. Die Lotmaterialpartikel weisen Durchmesser oder Außenabmessungen d110 auf, welche ein Vielfaches der Partikeldurchmesser oder Partikelmaximalabmessungen d120, d121 der magnetischen Nanopartikel sind. Das Lotmittel kann als Lötpaste aber auch als Preform vorliegen. Wird eine derartige Mixtur einem magnetischen Wechselfeld ausgesetzt, wird ein Strom in den Nanopartikeln 120, 121 induziert. Die Nanopartikel, z. B. CMP-Nanopartikel, dissipieren die magnetische Energie im Wesentlichen durch Relaxationsprozesse nach Brown und Neel, was zur Erwärmung und schließlich zum Aufschmelzen des Lotmaterials führt. Das magnetische Wechselfeld ist in den Figuren 4 und 5 durch Pfeile 200, 201 angezeigt. Ein erster Lötpartner 10, z. B. eine Platine, wird über ein Lotmittel 103 z. B. als Preform ausgebildet mit einem zweiten Lötpartner 20 z. B. einem Chip verbunden. Bei Erreichen der spezifischen Curie-Temperatur der Nanopartikel 120, 121 wird die induzierte Erwärmung schlagartig unterbrochen. Durch Variation der Zusammensetzung der Nanopartikel 120, 121 kann die Curie-Temperatur eingestellt werden. Damit kann ein Überhitzen des Lotmittels und der Lötstelle verhindert werden.

Durch die intrinsische Erwärmung des Lotmittels sinkt die gesamt notwendige Energie für den Löt- und Entlötprozess deutlich. Dadurch entstehen auch weniger Kosten sowie eine geringere CO₂-Belastung beim Lötprozess. Durch Verwendung unterschiedlich modifizierter CMPs 120, 121 können Bauteile 20 gelötet und später im Recyclingprozess selektiv entlötet werden.

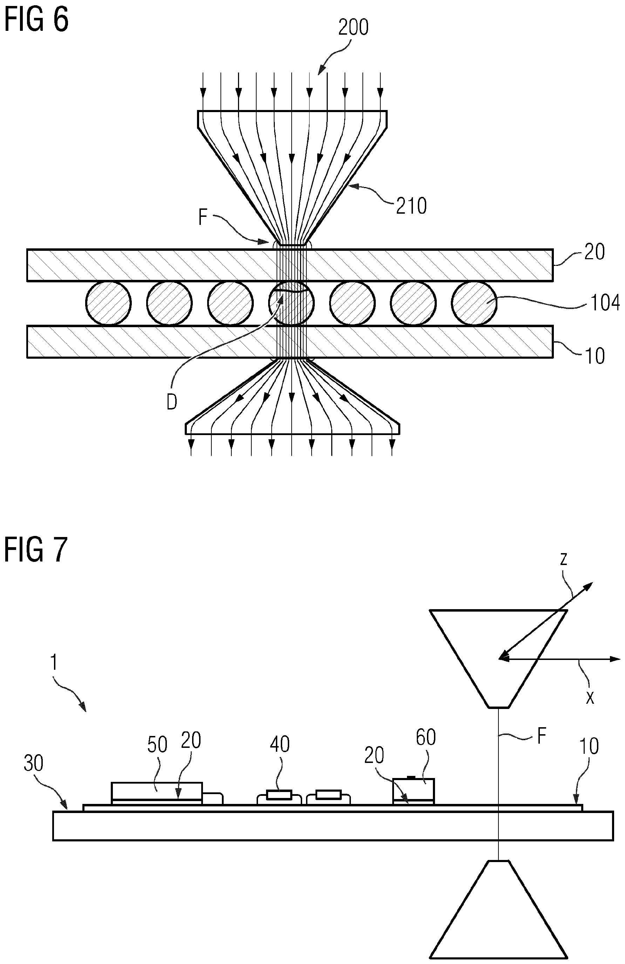

Durch zusätzliches Fokussieren des magnetischen Wechselfeldes 200, wie in Figur 6 gezeigt, kann die Selektivität des Lötens und Entlötens weiter erhöht werden und auch einzelne Pins selektiv erwärmt werden. In der Figur 6 sind wieder ein erster Lötpartner 10, ein zweiter Lötpartner 20 sowie einzelne Lotperlen 104 gezeigt, wie sie beispielsweise für Kugelgitteranordnungen bei sogenannten BGAs (Ball-Grid-Arrays) verwendet werden. Der Fokusbereich F des magnetischen Wechselfeldes 200 kann auf eine einzelne Lotperle gerichtet sein. Somit können sogenannte Cracks, einzelne Verbindungsdefekte D repariert werden.

In Figur 7 ist noch eine Variante gezeigt, wie ein Baugruppenrecycling auch automatisiert durch Verfahren einer Vorrichtung zum Erzeugen eines magnetischen Wechselfeldes, insbesondere eines fokussierten magnetischen Wechselfeldes, erfolgen kann. Entweder kann die Baugruppe 1 verfahren werden oder alternativ dazu die Magnetfeldvorrichtung. Eine Baugruppe 1 kann einen auf einem Schaltungsträger 30, also einem Substrat, welches den ersten Lötpartner darstellt, mehrere Bauelemente also Bauteile einer Baugruppe 40, 50, 60 aufweisen, die über unterschiedliche Lötverbindungen, z. B. eine flächige Anbindung 20 oder einzelne Pin-Anbindungen, wie bei dem Bauelement 40 gezeigt, aufweisen.

### Bezugszeichen:

100/101/102 Lotmittel
110 metallisches Lotmaterial (Lotpartikel)
120 magnetische Nanopartikel (CNP)
21 Kern
22 Hülle
130 Flussmittel
d110 Durchmesser der metallischen Lotpartikel
d120 Durchmesser der magnetischen Nanopartikel
300 Wärmeübertragung
200 magnetisches Wechselfeld
10 erster Lötpartner, z.B. Kupferschicht auf Schaltungsträger 30
20 zweiter Lötpartner, z.B. Bauelement, bzw. elektrische und/oder thermische Bauelementanbindung
103 Lotmittelschicht, z.B. Paste
30 intrinsische Erwärmung des Lotmittels als Folge der in den magnetischen Nanopartikeln (120) durch das magnetische Wechselfeld erzeugten Induktionsströme
201 zweites magnetisches Wechselfeld unterschiedlicher Magnetfeldstärke und/oder unterschiedlicher Wechselfrequenz zum ersten Magnetfeld
104 Lotperlen, z.B. für Kugelgitteranordnung (BGA Ball-Grid-Array)
D Crack, Defekt
210 Fokusierhilfe, z.B. umfassend eine erste und eine zweite Magnetspulenanordnung
F Fokusbereich
x Scanbewegungsrichtung in erster flächiger Ausdehnungsrichtung der Baugruppe 1
z Scanbewegungsrichtung in zweiter flächiger Ausdehnungsrichtung der Baugruppe 1
30 Schaltungsträger, Substrat, z.B. für eine Baugruppe 40/50/60 Bauelemente, Bauteile einer Baugruppe

## Patentansprüche

1. Verfahren zum Aufschmelzen eines Lotmaterials (110) zum Fügen und/oder zum Lösen wenigstens einer ersten und wenigstens einer zweiten Lötverbindung, wobei ein Lotmittel (100/101/102) das Lotmaterial (110) und magnetische Nanopartikel (120, 121) umfasst, welche ein ferromagnetisches oder ferrimagnetisches Material aufweisen und einen Gewichtsanteil am gesamten Lotmittel (100/101/102) zwischen 1% und 30% ausmachen, und wobei das Verfahren zumindest die folgenden Schritte aufweist:
- Einbringen einer ersten Leistung in ein erstes Lotmittel (100), mittels eines ersten magnetischen Wechselfeldes (200), sodass das erste Lotmittel (100) aufschmilzt,
- Einbringen einer zweiten Leistung in ein zweites Lotmittel (101), mittels eines zweiten magnetischen Wechselfeldes (200), sodass das zweite Lotmittel (101) aufschmilzt, wobei sich das erste und das zweite magnetische Wechselfeld so unterscheiden, dass das erste magnetische Wechselfeld nicht geeignet ist, das zweite Lotmittel aufzuschmelzen sowie das zweite magnetische Wechselfeld nicht geeignet ist, das erste Lotmittel aufzuschmelzen.

2. Verfahren nach Anspruch 1, bei dem die Wechselfrequenz des ersten magnetischen Wechselfelds (200) auf die Größe (d120, d121) der magnetischen Nanopartikel (120) des ersten Lotmittels (100) eingestellt ist und bei dem die Wechselfrequenz des zweiten magnetischen Wechselfelds (201) auf die Größe (d120, d121) der magnetischen Nanopartikel (120, 121) des zweiten Lotmittels (101) eingestellt ist.

3. Verfahren nach Anspruch 1 oder 2, bei dem die Wechselfrequenz des ersten magnetischen Wechselfelds (200) auf den Volumenanteil der magnetischen Nanopartikel (120) an der Zusammensetzung des ersten Lotmittels (100) eingestellt ist und bei dem die Wechselfrequenz des zweiten magnetischen Wechselfelds (201) auf den Volumenanteil der magnetischen Nanopartikel (120, 121) an der Zusammensetzung des zweiten Lotmittels (101) eingestellt ist.

4. Verfahren nach einem der vorstehenden Ansprüche, bei dem wenigstens ein magnetisches Wechselfeld (200) als fokussiertes magnetisches Wechselfeld erzeugt wird, und welches zusätzlich wenigstens den Schritt umfasst:
Einbringen des Lotmittels (100/101/102) in den Fokusbereich (F) des fokussierten magnetischen Wechselfeldes.

5. Verfahren nach Anspruch 4, bei dem das Einbringen durch Verschieben des Fokusbereichs (F) über das Lotmittel (100/101/102) und/oder Verschieben einer Lötverbindungsposition in den Fokusbereich (F) erfolgt.

6. Verfahren nach einem der vorhergehenden Ansprüche 4 oder 5, bei welchem die Erzeugung des fokussierten magnetischen Wechselfelds (F, 200, 201) mittels wenigstens zwei Magnetspulen (210,220) unterschiedlicher Orientierung der magnetischen Pole erfolgt.

7. Verfahren nach einem der vorstehenden Ansprüche, bei welchem die magnetischen Nanopartikel (120) einen Durchmesser (d120, d121) unterhalb von 100 nm aufweisen.

8. Verfahren nach einem der vorstehenden Ansprüche, bei welchem die magnetischen Nanopartikel (120) superparamagnetisch sind.

9. Verfahren nach einem der vorhergehenden Ansprüche, bei welchem die magnetischen Nanopartikel (120) eine Curie-Temperatur aufweisen, welche in einem Bereich zwischen 100°C und 1200 °C, insbesondere zwischen 150 °C und 400 °C, liegt.

10. Verfahren nach einem der vorhergehenden Ansprüche, bei welchem die Verteilung der Curie-Temperaturen der einzelnen magnetischen Nanopartikel (120,121) eine Halbwertsbreite (FWHM) von höchstens 50 °C, insbesondere von höchstens 30 °C aufweist.

11. Verfahren nach einem der vorhergehenden Ansprüche, bei welchem das ferromagnetische oder das ferrimagnetische Material eine metallische Legierung oder ein Metalloxid umfasst, wobei die Legierung oder das Metalloxid zumindest eines der Elemente Eisen, Cobalt und Nickel aufweist.

12. Baugruppe (1) aufweisend wenigstens zwei Lötverbindungen, welche durch ein Verfahren nach einem der vorstehenden Ansprüche gefügt und/oder lösbar sind, wobei eine Lötverbindung einen ersten Lötpartner (10) und einen zweiten Lötpartner (20) umfasst, welche Lötpartner (10,20) durch ein Lotmittel (100) verbindbar oder verbunden sind, welches Lotmittel (100) ein metallisches Lotmaterial (110) und eine Vielzahl von darin eingebetteten magnetischen Nanopartikeln umfasst, wobei sich die Lotmittelzusammensetzung der zweiten Lötverbindung von der Lotmittelzusammensetzung der ersten Lötverbindung unterscheidet.

13. Baugruppe (1) nach Anspruch 12, bei welcher der erste Lötpartner (10) ein elektrischer Schaltungsträger ist und die zweiten Lötpartner (20) elektrische oder elektronische Bauelemente sind.
